# EUROPÄISCHE PATENTSCHRIFT

(11) **EP 2 641 062 B1**
(45) Veröffentlichungstag und Bekanntmachung des Hinweises auf die Patenterteilung: **02.03.2016**
(21) Anmeldenummer: 11787647.4
(22) Anmeldetag: 15.11.2011
(51) Int. Cl.: G01D 5/353

(54) **MESSGERÄT ZUR BESTIMMUNG UND/ODER ÜBERWACHUNG MINDESTENS EINER PROZESSGRÖßE**
MEASURING DEVICE FOR DETERMINING AND/OR MONITORING AT LEAST ONE PROCESS VARIABLE
APPAREIL DE MESURE PERMETTANT DE DÉTERMINER ET/OU DE SURVEILLER AU MOINS UNE GRANDEUR DE PROCESSUS

(30) Priorität: 19.11.2010 DE 102010044180
(43) Veröffentlichungstag der Anmeldung: 25.09.2013
(73) Patentinhaber: Endress+Hauser GmbH+Co. KG, 79689 Maulburg (DE)
(72) Erfinder: WERNET, Armin, 79618 Rheinfelden (DE); UPPENKAMP, Kaj, 79664 Wehr (DE); FERRARO, Franco, 79739 Schwörstadt (DE); BRUTSCHIN, Wolfgang, 79650 Schopfheim (DE)
(74) Vertreter: Andres, Angelika Maria
(86) Internationale Anmeldenummer: PCT/EP2011/070100
(87) Internationale Veröffentlichungsnummer: WO 2012/065968

(56) Entgegenhaltungen:
- EP-A1- 0 780 822
- EP-A1- 2 230 525
- WO-A2-03/021839
- DE-A1-102006 051 900

## Beschreibung

Die vorliegende Erfindung betrifft ein Messgerät zur Bestimmung und/oder Überwachung mindestens einer Prozessgröße mit einer Sensoreinheit mit mindestens einem für die Prozessgröße sensitiven Sensor. Bei der Prozessgröße handelt es sich beispielsweise um einen Füllstand, die Dichte, die Viskosität, die Temperatur, den Druck, oder den pH-Wert eines Mediums.

Zur Bestimmung und/oder Überwachung von Prozessgrößen ist in der Prozess- und Automatisierungstechnik eine Vielzahl an verschiedenartigen Messgeräten bekannt. Ein Beispiel für ein Füllstandsmessgerät ist der von der Anmelderin hergestellte und vertriebene "Liquiphant", welcher auf einem vibronischen Messprinzip beruht und dessen Sensoreinheit eine zu mechanischen Schwingungen anregbare Schwinggabel aufweist. Für den Einsatz in explosionsgefährdeten Bereichen weisen derartige Messgeräte oftmals eine galvanische Trennung auf, durch welche beispielsweise der mediumsberührende Sensorteil des Messgerätes, der sich in dem explosionsgefährdeten Bereich befindet, von der Energieversorgung oder von Bedienelementen getrennt ist. Über die galvanische Trennung erfolgt meist nicht nur die Energieversorgung der Sensoreinheit, sondern auch die Kommunikation mit dieser. In der Regel weist das Messgerät hierzu zwei Elektronikeinheiten auf, zwischen denen eine galvanisch getrennte Schnittstelle besteht. Diese wird beispielsweise durch mindestens einen Kondensator oder Transformator realisiert.

Eine Form der Energie- und Datenübertragung über eine Schnittstelle mit einem Transformator ist in der DE 10 2006 051 900 A1 beschrieben. Hiernach erfolgt die Datenübertragung von der ersten Elektronikeinheit zur zweiten Elektronikeinheit über eine Modulation der Frequenz und/oder Amplitude der Energieübertragung, während Daten von der zweiten zur ersten Elektronikeinheit mittels einer Modulation des Strombedarfs der zweiten Elektronikeinheit übertragen werden. Beide Elektronikeinheiten enthalten einen Prozessor. Die Ansteuerung des Transformators erfolgt über analog ausgeführte Bauteile, welche die Parameter der Signalübertragung, wie beispielsweise Impuls- oder Pausendauer, festlegen. Die festgesetzten Parameter bringen den Nachteil mit sich, dass der Wirkungsgrad der Energieübertragung nur unter bestimmten Bedingungen maximal ist. Eine Umgestaltung der Hardwareschaltung, welche es ermöglicht, auf den Wirkungsgrad durch Änderung der Parameter Einfluss zu nehmen, wäre mit nicht praktikablem Schaltungsaufwand verbunden.

Ein weiterer Nachteil ergibt sich bei der Inbetriebnahme des Messgeräts. Während des Hochfahrens müssen bestimmte Vorschriften eingehalten werden. So dürfen 4-20mA Geräte beispielsweise währenddessen keine Werte annehmen, die innerhalb dieses Messwerten zugeordneten Bereichs liegen, um das Auslösen einer entsprechenden Reaktion nachfolgender Geräte zu verhindern. Da analoge Bauteile über keine Kontrollfunktion verfügen und daher ein Überschreiten der vorgegebenen Grenzen nicht detektieren könnte, ist es üblich, das Hochfahren des Geräts mit einem Strom durchzuführen, welcher deutlich unterhalb oder oberhalb des Messwertbereichs liegt, z.B. < 3,6mA. Das Hochfahren erfordert dann entsprechend viel Zeit. Ein Messgerät sollte jedoch so schnell wie möglich betriebsbereit sein.

Die Aufgabe der Erfindung besteht darin, ein Messgerät eingangs genannter Art bereit zu stellen, deren Energie- und/oder Datenübertragung an die aktuellen Erfordernisse angepasst ist. Weiterhin ist ein Verfahren zum Betreiben eines derartigen Messgeräts anzugeben, welches eine Anpassung der Energie- und/oder Datenübertragung an die aktuellen Erfordernisse ermöglicht.

Die Aufgabe wird bezüglich des Messgeräts dadurch gelöst, dass der erste Mikrocontroller mindestens ein in mindestens einer Kenngröße variierbares Signal erzeugt und der Übertragungseinheit zuführt, dass das Signal die Energie- und Datenübertragung steuert, dass der erste Mikrocontroller und/oder der zweite Mikrocontroller mindestens einen aktuellen Betriebsparameter bestimmt, und dass der erste Mikrocontroller zumindest eine Kenngröße des Signals in Abhängigkeit des Betriebsparameters einstellt.

Der erste und/oder der zweite Mikrocontroller bestimmt bevorzugt den aktuellen Betriebszustand oder den aktuellen Wirkungsgrad der Energieübertragung als Betriebsparameter. Verschiedene Betriebszustände sind beispielsweise Inbetriebnahme, Messbetrieb, und Standby oder Energiesparmodus. Die einstellbaren Kenngrößen des Signals sind beispielsweise Frequenz, Impulsdauer, Pausendauer oder das Impulsdauer-Pausendauer-Verhältnis.

Bislang lieferten eventuell in der Elektronikeinheit vorhandene Prozessoren lediglich ein binäres Steuersignal zur Steuerung nachgestellter Komponenten, welche dann die eigentlichen Signale zur Energie- und/oder Datenübertragung erzeugten. Erfindungsgemäß erzeugt der primärseitige Mikrocontroller nun direkt das Steuersignal zur Energie- und/oder Datenübertragung. Hierdurch ist eine hohe Flexibilität in der Gestalt des Signals ermöglicht. Durch die variable Frequenz oder das variable Impuls-Pausen-Verhältnis ist das Signal an aktuelle Anforderungen wie z.B. den Energiebedarf anpassbar. Der erste Mikrocontroller passt das Signal dynamisch an die aktuellen Anforderungen an bzw. ermöglicht weiterhin eine Anpassung des Signals an sich verändernde Umgebungsbedingungen, wie beispielsweise die Temperatur. Die Kenngrößen des Signals sind nicht fest voreingestellt, sondern werden ständig geregelt.

In einer ersten Ausgestaltung der erfindungsgemäßen Lösung passt der erste Mikrocontroller zumindest eine Kenngröße des Signals derart an einen aktuellen Betriebszustand des Messgeräts an und/oder stellt sie derart ein, dass der Wirkungsgrad der Energieübertragung optimiert ist. Insbesondere ist bei einer kontinuierlichen Überwachung des Wirkungsgrads eine Regelung des Wirkungsgrads durch optimale Anpassung der Kenngrößen und/oder eine Aussage über den Zustand des Messgeräts im Hinblick auf vorausschauende Wartung möglich. An Stelle des Wirkungsgrads kann beispielsweise auch die Ausgangsspannung optimiert werden.

Gemäß einer Ausgestaltung ist die von dem ersten Mikrocontroller eingestellte Kenngröße des Signals die Frequenz des Signals und/oder das Impulsdauer-Pausendauer-Verhältnis. Beispielsweise bestimmt mindestens einer der Mikrocontroller den aktuellen Wirkungsgrad als Betriebsparameter und der erste Mikrocontroller passt zu dessen Optimierung das Impulsdauer-Pausendauer-Verhältnis des Signals an.

Bei einer Weiterbildung der Erfindung weist die Übertragungseinheit mindestens einen Transformator auf. Hierbei kann es sich um einen Fluss- oder Sperrwandler handeln.

In einer Ausgestaltung des erfindungsgemäßen Messgeräts handelt es sich bei der Übertragungseinheit um einen Gegentaktwandler, vorzugsweise einen Gegentaktflusswandler. Zur Gegentaktansteuerung sind zwei Steuersignale erforderlich, sodass der erste Mikrocontroller entsprechend ein erstes und ein zweites Signal erzeugt, wobei das zweite Signal im Wesentlichen einem invertierten ersten Signal entspricht.

Eine vorteilhafte Ausgestaltung des Messgeräts sieht vor, dass der erste Mikrocontroller eine aktuelle Eingangsleistung der Übertragungseinheit erfasst, dass der zweite Mikrocontroller eine aktuelle Ausgangsleistung der Übertragungseinheit erfasst, und dass der erste Mikrocontroller und/oder der zweite Mikrocontroller aus der erfassten Eingangsleistung und der erfassten Ausgangsleistung den aktuellen Wirkungsgrad der Energieübertragung ermittelt. Bevorzugt ermittelt der erste Mikrocontroller den Wirkungsgrad. An Hand des Wirkungsgrads ist der optimale Arbeitspunkt der Energie- und Datenübertragung ermittelbar. Durch die Variabilität des Signals zur Steuerung der Energie- und Datenübertragung sind die Kenngrößen des Signals derart regelbar, dass die Übertragung jederzeit am optimalen Arbeitspunkt erfolgt. Dies macht das Messgerät sehr energieeffizient.

In einer besonders vorteilhaften Ausführungsform wertet das Messgerät den Wirkungsgrad zu Diagnosezwecken aus, insbesondere im Hinblick auf Predictive Maintenance. Durch eine kontinuierliche Überwachung des Wirkungsgrads kann eine Prognose erstellt werden, wann ein abnehmender Wirkungsgrad unter einen für einen ungestörten Betrieb des Messgeräts erforderlichen Wert gesunken sein wird und somit eine Wartung oder ein Austausch des Messgeräts notwendig sein wird. Eine Verschlechterung des Wirkungsgrades kann durch Alterung der Bauteile der Elektronikeinheiten, sowie durch Umgebungsbedingungen wie z.B. ein hoher Feuchtegehalt oder hohe Temperaturen, verursacht sein. In einer Ausgestaltung weist das Messgerät weiterhin einen Temperatursensor zur Überwachung der Temperatur auf. Die Information über die Temperatur kann ebenfalls für die Diagnose verwendet werden.

Gemäß einer hiermit verbundenen Ausgestaltung bestimmt der erste Mikrocontroller und/oder der zweite Mikrocontroller aus dem ermittelten Wirkungsgrad, ob im Transformator ein Wicklungsbruch vorliegt und erzeugt im Fall eines Wicklungsbruchs eine entsprechende Fehlermeldung. Das Messgerät ist durch die Auswertung des ermittelten Wirkungsgrads in der Lage, sich selbst auf Wicklungsbruch zu überwachen.

Eine Ausgestaltung der Erfindung sieht vor, dass der erste Mikrocontroller über verschiedene Betriebsmodi verfügt, welche durch bestimmte Werte mindestens einer Kenngröße des Signals gekennzeichnet sind, dass jedem Betriebszustand des Messgeräts ein Betriebsmodus zugeordnet ist, und dass der Mikrocontroller in Abhängigkeit des aktuellen Betriebszustandes den entsprechenden Betriebsmodus einstellt. Für einen Betriebsmodus ist zumindest ein Satz Startwerte für die Kenngrößen definiert. Im weiteren Verlauf passt der erste Mikrocontroller die Kenngrößen falls erforderlich an die aktuellen Erfordernisse an. Ist beispielsweise der Energiebedarf der Sensoreinheit geringer als erwartet, sodass eine geringere Energieübertragung ausreicht, verringert der erste Mikrocontroller die Impulsdauer bzw. das Impulsdauer-Pausendauer-Verhältnis des Signals zur Steuerung der Energieübertragung. Steigt der Bedarf an, erhöht der erste Mikrocontroller das Verhältnis wieder.

Gemäß einer Weiterbildung erfasst der erste Mikrocontroller eine Kennung der Sensoreinheit, und stellt in Abhängigkeit der vorhandenen Sensoreinheit die mindestens eine Kenngröße des Signals derart ein, dass die Energieübertragung an den Energiebedarf der jeweiligen Sensoreinheit angepasst ist. Zudem sind die Kenngrößen dynamisch regelbar.

Die der Erfindung zugrunde liegende Aufgabe wird weiterhin durch ein Verfahren zum Betreiben eines Messgeräts mit den eingangs genannten Merkmalen gelöst. Die Lösung besteht darin, dass mindestens ein Signal mit mindestens einer variierbaren Kenngröße erzeugt und der Übertragungseinheit zugeführt wird, dass von dem Signal die Energie- und Datenübertragung gesteuert werden, dass mindestens ein aktueller Betriebsparameter bestimmt wird, und dass zumindest eine Kenngröße des Signals in Abhängigkeit des Betriebsparameters eingestellt wird.

Unter Kenngrößen sind für das Signal charakteristische Größen wie Frequenz und Impulsdauer-Pausendauer-Verhältnis zu verstehen. In einer bevorzugten Ausgestaltung der Übertragungseinheit umfasst diese einen Gegentaktwandler. Bevorzugt werden zur Steuerung daher ein erstes Signal und ein zweites Signal erzeugt, wobei das zweite Signal im Wesentlichen einem invertierten ersten Signal entspricht. In einer Ausgestaltung des Verfahrens wird das mindestens eine Signal an die Betriebsbedingungen angepasst, d.h. beispielsweise der sensorseitige Energieverbrauch ermittelt und die Energieübertragung entsprechend geregelt. Somit wird die Effizienz der Energieübertragung bzw. der Wirkungsgrad optimiert. In einer Variante wird von der ersten Elektronikeinheit erkannt, welcher Sensortyp vorliegt, und die Kenngrößen entsprechend den typischen Anforderungen, wie z.B. Energiebedarf, des jeweiligen Sensortyps eingestellt. Im weiteren Verlauf werden die Kenngrößen dynamisch an die aktuellen Anforderungen angepasst. Die Sensorerkennung erfolgt hierbei typischerweise über die Kommunikation mit dem Mikrocontroller der Sekundärseite oder über einen entsprechend gesetzten Port. In einer Ausgestaltung wird der Betriebszustand ermittelt und das Signal entsprechend erzeugt. Beispielsweise wird eine Startroutine definiert, mit welcher das System sicher vom ausgeschalteten Zustand oder vom Ruhezustand in den aktiven Messzustand überführt werden kann.

Die Erfindung wird anhand der nachfolgenden Figuren für das Messgerät und das Verfahren gemeinsam näher erläutert.
- Fig. 1: zeigt eine schematische Darstellung der Komponenten eines erfindungsgemäßen Messgeräts;
- Fig. 2: zeigt ein Blockschaltbild der elektronischen Komponenten.

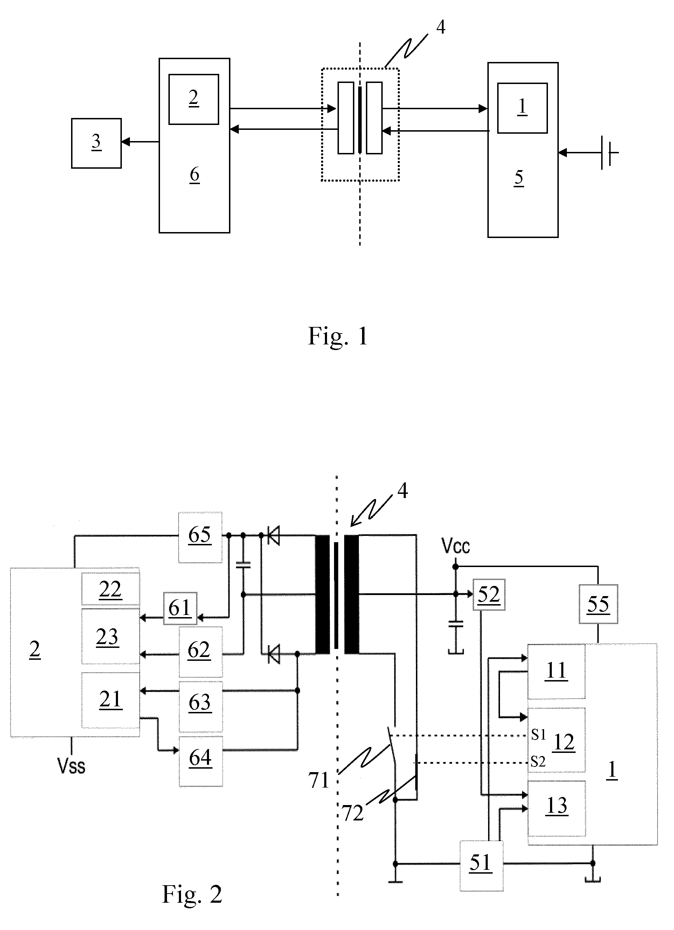

In Fig. 1 sind die wesentlichen Komponenten eines erfindungsgemäßen Messgeräts dargestellt. Der Sensor 3 und die zweite Elektronikeinheit 6 bilden die Sensoreinheit. Bei dem Sensor 3 handelt es sich beispielsweise um eine schwingfähige Einheit, insbesondere eine Schwinggabel, welche von einer Antriebseinheit zu mechanischen Schwingungen angeregt wird. Diese ist durch eine galvanisch getrennte Schnittstelle in Form der Übertragungseinheit 4 mit der ersten Elektronikeinheit 5 verbunden. Über die erste Elektronikeinheit 5 erfolgt die Energieversorgung der Sensoreinheit, sodass die dem Sensor 3 zugeordnete Seite der galvanischen Trennung als Sekundärseite und die der ersten Elektronikeinheit 5 zugeordnete Seite als Primärseite bezeichnet werden kann. Neben der Energiequelle können sich auf der Primärseite weitere Komponenten wie z.B. Anzeigeelemente, Schnittstellen zu Bedienelementen oder die Bedienelemente selbst befinden.

Fig. 2 offenbart ein schematisches Blockschaltbild der ersten Elektronikeinheit 5, zweiten Elektronikeinheit 6 und Übertragungseinheit 4. Die erste Elektronikeinheit 5 weist einen ersten Mikrocontroller 1 auf, welcher über eine digitale Schnittstelle 11, einen Timer 12 und einen Analog/Digital-Wandler 13 verfügt. Der erste Mikrocontroller 1 erhält die von ihm benötigte Energie über einen Spannungsregler 55 von der Spannungsquelle V_{cc}, welche die Versorgungsspannung für die Übertragungseinheit 4 bereitstellt. Bei der Übertragungseinheit 4 handelt es sich bevorzugt um einen Gegentaktwandler, insbesondere einen Gegentaktflusswandler, mit einem Transformator mit Mittelanzapfung. Auf der Primärseite wird die Transformatormittelanzapfung mit der Versorgungsspannung V_{cc} verbunden. Das jeweils andere Ende ist über einen steuerbaren Schalter 71, 72 mit einer Masse verbindbar.

Die Ansteuerung des Gegentaktwandlers erfolgt digital mittels des ersten Mikrocontrollers 1. Die digitale Schnittstelle 11 steuert den Eingang des Timers 12 an. Beispielsweise handelt es sich bei der digitalen Schnittstelle 11 um eine UART. In einer alternativen Ausgestaltung wird der Timer 12 intern, d.h. von einem Signal innerhalb des ersten Mikrocontrollers 1, angesteuert. Der Timer 12 besitzt zwei Ausgänge, an welchen ein erstes Signal S1 und ein zweites Signal S2 ausgegeben werden. Während des anliegenden Low-Pegels erzeugt der Timer 12 das erste Signal S1 mit einer Frequenz f1; während des High-Pegels mit einer Frequenz f2. Mit anderen Worten erzeugt der Timer 12 ein frequenzmoduliertes Signal S1, wobei die Frequenz f1 einer logischen Null und die Frequenz f2 einer logischen Eins entspricht.

Das erste Signal S1 steuert den ersten Schalter 71. Das zweite Signal S2 steuert den zweiten Schalter 72 und entspricht im Wesentlichen einem invertierten ersten Signal S1. Die Flanken der Impulse des zweiten Signals S2 sind jedoch gegenüber denen des ersten Signals S1 derart um eine Pausenzeit tp versetzt, dass zu keiner Zeit beide Signale S1, S2 gleichzeitig auf High-Pegel liegen, da dies einen Kurzschluss zur Folge hätte. Die Schalter 71, 72 können beispielsweise in Form von Transistoren implementiert sein.

Die unterschiedlichen Frequenzen f1 und f2 dienen der Kommunikation von der Primärseite zur Sekundärseite. Zur Übertragung einer logischen 0 erzeugt der Timer 12 die Signale mit der Frequenz f1; zur Übertragung einer logischen 1 mit der Frequenz f2. Gleichzeitig wird mit den Signalen S1 und S2 auch die Energieübertragung gesteuert. Je länger die Impulsdauer der Signale S1, S2 ist, desto höher ist die eingespeiste Energiemenge, wobei der Übertragung dieser Energie durch die Sättigung des Transformatorkerns Grenzen gesetzt sind. Außerhalb der Kommunikationsphasen liegt beispielsweise das der logischen 1 entsprechende Signal S1, S2 mit der Frequenz f2 an. Die Impulsdauer der Signale S1, S2 mit der Frequenz f2 bestimmt daher die übertragene Energie. Erfindungsgemäß wird die Energieübertragung an den aktuellen Energiebedarf angepasst. Hierzu bestimmt der zweite Mikrocontroller 2 auf der Sekundärseite den aktuellen Energiebedarf und teilt diesen dem ersten Mikrocontroller 1 mit, woraufhin dieser das Impulsdauer-Pausendauer-Verhältnis entsprechend einstellt. Die Frequenzen f1, f2 sind beliebig einstellbare Teiler des Systemtakts des ersten Mikrocontrollers 1. Da das zweite Signal S2 im Wesentlichen gleich dem invertierten ersten Signal S1 ist, versteht sich von selbst, dass bei einer Änderung der Kenngrößen die Kenngrößen des ersten Signals S1 und die Kenngrößen des zweiten Signals S2 gleichermaßen geändert werden.

Analog zur ersten Elektronikeinheit 5 weist die zweite Elektronikeinheit 6 einen zweiten Mikrocontroller 2 auf, welcher über einen Timer 22, eine digitale Schnittstelle 21 und einen Analog-/Digital-Wandler 23 verfügt. Die Versorgungsenergie erhält der zweite Mikrocontroller 2 über den Spannungsregler 65 von der Übertragungseinheit 4.

Der Spannungsregler 65 regelt die übertragene Spannung auf die erforderliche Eingangsspannung des zweiten Mikrocontrollers 2 herunter. Das Massepotential des zweiten Mikrocontrollers 2 ist hier mit Vₛₛ bezeichnet.

Zur Entschlüsselung der übertragenen Information weist die sekundärseitige zweite Elektronikeinheit 6 einen Demodulator 63 auf. Dieser wandelt das frequenzmodulierte Signal wieder in ein binäres Signal um. Beispielsweise ist der Demodulator 63 ein Tiefpass oder Bandpass, dessen Grenzfrequenz bzw. Grenzfrequenzen entsprechend den Frequenzen f1 und f2 eingestellt ist bzw. sind.

Die zweite Elektronikeinheit 6 weist einen Stromwandler 61 und einen Pegelwandler 62 auf. Der Stromwandler 61 enthält einen Widerstand zur Umwandlung der anliegenden Spannung in einen entsprechenden Strom und führt diesen dem Analog-/Digital-Wandler 23 zu. Der Pegelwandler 62 empfängt die übertragene Spannung und leitet sie an den Analog-/Digital-Wandler 23 weiter, indem er die Spannung an den digitalisierbaren Bereich des Analog-/Digital-Wandlers 23 bzw. die Versorgungsspannung des zweiten Mikrocontrollers 2 anpasst. Aus den aktuellen Werten für Strom und Spannung bestimmt der zweite Mikrocontroller 2 die aktuelle Leistung.

Zur Kommunikation mit der Primärseite greift die Sekundärseite auf eine pulsartige Strommodulation zurück. Der mit dem Signalausgang der digitalen Schnittstelle 21 verbundene Strommodulator 64 erhöht hierzu während des Anliegens einer logischen Eins den Strombedarf der Sekundärseite. In einer vorteilhaften Ausgestaltung wird der Strombedarf nicht für die gesamte Impulsdauer des von der digitalen Schnittstelle 21 ausgegebenen Signals gleichmäßig erhöht, sondern es werden während der Impulsdauer mehrere kurze Stromimpulse erzeugt, sodass der zusätzliche Stromverbrauch gering gehalten wird.

Um die Strommodulation und somit die von der Sekundärseite übermittelte Information zu entschlüsseln weist die erste Elektronikeinheit 5 auf der Primärseite einen Stromwandler 51 auf. Dieser ist den beiden Schaltern 71, 72 nachgeschaltet und mit der Masse des ersten Mikrocontrollers 1 verbunden. Der Stromwandler 51 enthält zumindest einen Widerstand bekannten Werts, über welchen der Strom in eine entsprechende Spannung umgewandelt wird. Zur Ermittlung des Stromverbrauchs führt der Stromwandler 51 diese Spannung dem Analog-/Digital-Wandler 13 zu. Zudem enthält der Stromwandler 51 einen Demodulator, der das Kommunikationssignal für die digitale Schnittstelle 11 aufbereitet und dieser das aufbereitete Signal zuführt.

Der ermittelte Stromwert dient neben der Ermittlung des durch die Strommodulation übermittelten Informationsgehalts der Bestimmung der aktuellen primärseitigen Leistung. Hierzu ist zudem die Kenntnis der aktuell anliegenden Spannung notwendig. Die Information über die aktuell anliegende Spannung wird dem ersten Mikrocontroller 1 von dem Pegelwandler 52 bereitgestellt. Dieser passt die Spannung an den digitalisierbaren Bereich des Analog-/Digital-Wandlers 13 an und führt sie diesem zu. Bei bekanntem Teilungsverhältnis ist dem Mikrocontroller 1 die tatsächliche Spannung somit bekannt, sodass er die Leistung ermitteln kann.

Bevorzugt übermittelt der zweite Mikrocontroller 2 dem ersten Mikrocontroller 1 die sekundärseitig gemessene Leistung. Der erste Mikrocontroller 1 bestimmt dann den aktuellen Wirkungsgrad der Übertragung. Ist der Wirkungsgrad nicht optimal, regelt der erste Mikrocontroller 1 beispielsweise die Kenngrößen der Signale S1, S2 derart, dass sich der Wirkungsgrad erhöht. Erhöht sich der Wirkungsgrad trotz Nachregelung der Kenngrößen nicht wie erwartet, liegt wahrscheinlich ein Wicklungsbruch vor und der Mikrocontroller 1 erzeugt eine Fehlermeldung. In einer Ausgestaltung steuert der Mikrocontroller 1 zuvor die beiden Spulen separat an und bestimmt jeweils den Wirkungsgrad. In einer anderen Ausgestaltung regelt der erste Mikrocontroller 1 die eingespeiste Energie hoch, wenn die Sekundärseite eine Abnahme der Leistung oder übertragenen Energie meldet. Erhöht sich die Leistung bzw. die übertragene Energie daraufhin nicht, erzeugt der erste Mikrocontroller 1 eine Fehlermeldung. Die Fehlermeldung erfolgt beispielsweise in Form des Setzens einer LED am Gerät oder einer Aufforderung zur Wartung über ein Bussystem.

Bevorzugt sind in dem ersten Mikrocontroller 1 verschiedene Betriebsmodi implementiert, welche sich durch einen Satz bestimmter Kenngrößen auszeichnen. Jedem Betriebszustand ist dann ein Betriebsmodus zugeordnet. Der Betriebszustand wird automatisch erkannt und der entsprechende Betriebsmodus eingestellt, d.h. die Signale S1, S2 mit den entsprechenden Frequenzen f1, f2 und dem entsprechenden Impulsdauer-Pausendauer-Verhältnis erzeugt.

Ein Betriebszustand ist beispielsweise das Hochfahren des Messgeräts bei der Inbetriebnahme oder aus dem Standby-Betrieb. Bevorzugt ist eine Startup-Routine mit dynamischer Stromregelung vorgegeben. Der Stromverbrauch von 4-20mA Geräten muss während des Hochfahrens außerhalb des 4-20mA-Bereichs liegen. Erfindungsgemäß ist mit dem Stromwandler 51 eine Kontrollfunktion in der ersten Elektronikeinheit 5 implementiert, mit welcher der aktuelle Stromverbrauch erfassbar ist. Bevorzugt wird daher ein nur knapp unterhalb des unzulässigen Bereichs liegender Strom verwendet und gegebenenfalls heruntergeregelt, falls der Stromverbrauch ansteigt. Dies beschleunigt den Startup-Vorgang und erhöht somit die Verfügbarkeit des Messgerätes.

Ein weiterer Betriebszustand ist der Messbetrieb. Überwiegend wird während des Messbetriebs Energie von der Primärseite zur Sekundärseite übertragen, indem das der logischen Eins entsprechende Signal an der Übertragungseinheit anliegt. Die entsprechende Frequenz und das Impulsdauer-Pausendauer-Verhältnis sind an den Energiebedarf der Sensoreinheit bzw. Sekundärseite angepasst. Bevorzugt besitzt die Primärseite eine Funktion zur automatischen Sensortyperkennung und wählt die Kenngrößen entsprechend des sensorspezifischen Energieverbrauchs. Vorteilhaft verfügt der erste Mikrocontroller 1 für jede mit der Primärseite verbindbare Sensoreinheit über einen dem Messbetrieb dieser Sensoreinheit zugeordneten Betriebsmodus, wobei einem Betriebsmodus auch mehrer Sensoreinheiten zugeordnet sein können. Selbstverständlich erfolgt auch hier falls erforderlich eine dynamische Anpassung der Kenngrößen während des Messbetriebs, z.B. im Fall eines erhöhten Strombedarfs oder zur Optimierung des Wirkungsgrads.

### Bezugszeichenliste

- 1: Erster Mikrocontroller
- 11: Digitale Schnittstelle
- 12: Timer
- 13: Analog/Digital-Wandler
- 2: Zweiter Mikrocontroller
- 21: Digitale Schnittstelle
- 22: Timer
- 23: Analog-/Digital-Wandler
- 3: Sensor
- 4: Übertragungseinheit
- 5: Erste Elektronikeinheit
- 51: Stromwandler
- 52: Pegelwandler
- 55: Spannungsregler
- 6: Zweite Elektronikeinheit
- 61: Stromwandler
- 62: Pegelwandler
- 63: Demodulator
- 64: Strommodulator
- 65: Spannungsregler
- 71: Schalter
- 72: Schalter
- S1: (Erstes) Signal
- S2: Zweites Signal
- Vₛₛ: Bezugspotential des zweiten Mikrocontrollers
- V_{cc}: Gleichspannungsquelle

## Patentansprüche

1. Messgerät zur Bestimmung und/oder Überwachung mindestens einer Prozessgröße mit einer Sensoreinheit mit mindestens einem für die Prozessgröße sensitiven Sensor (3), mit einer ersten Elektronikeinheit (5), welche einer Energieversorgungseinheit zugeordnet ist und welche einen ersten Mikrocontroller (1) aufweist, und mit einer zweiten Elektronikeinheit (6), welche der Sensoreinheit zugeordnet ist und einen zweiten Mikrocontroller (2) aufweist, und welche mit der ersten Elektronikeinheit (5) über eine galvanisch getrennte Übertragungseinheit (4) zur Energie- und Datenübertragung verbunden ist,
wobei der erste Mikrocontroller (5) mindestens ein in mindestens einer Kenngröße variierbares Signal (S1, S2) erzeugt und der Übertragungseinheit (4) zuführt,
wobei das Signal (S1, S2) die Energie- und Datenübertragung steuert, **dadurch gekennzeichnet,**
**dass** der erste Mikrocontroller (1) und/oder der zweite Mikrocontroller (2) mindestens einen aktuellen Betriebsparameter bestimmt,
und
**dass** der erste Mikrocontroller (1) zumindest eine Kenngröße des Signals (S1, S2) in Abhängigkeit des Betriebsparameters einstellt.

2. Messgerät nach Anspruch 1,
**dadurch gekennzeichnet,**
**dass** der erste Mikrocontroller (1) zumindest eine Kenngröße des Signals (S1, S2) an einen aktuellen Betriebszustand des Messgeräts anpasst und/oder derart einstellt, dass der Wirkungsgrad der Energieübertragung optimiert ist.

3. Messgerät nach Anspruch 1 oder 2,
**dadurch gekennzeichnet,**
**dass** die von dem ersten Mikrocontroller (1) eingestellte Kenngröße des Signals (S1, S2) die Frequenz des Signals (S1, S2) und/oder das Impulsdauer-Pausendauer-Verhältnis ist.

4. Messgerät nach einem der vorangehenden Ansprüche,
**dadurch gekennzeichnet,**
**dass** die Übertragungseinheit (4) mindestens einen Transformator aufweist.

5. Messgerät nach Anspruch 4,
**dadurch gekennzeichnet,**
**dass** es sich bei der Übertragungseinheit (4) um einen Gegentaktwandler handelt.

6. Messgerät nach einem der vorangehenden Ansprüche,
**dadurch gekennzeichnet,**
**dass** der erste Mikrocontroller (1) eine aktuelle Eingangsleistung der Übertragungseinheit (4) erfasst,
**dass** der zweite Mikrocontroller (2) eine aktuelle Ausgangsleistung der Übertragungseinheit (4) erfasst,
und
**dass** der erste Mikrocontroller (1) und/oder der zweite Mikrocontroller (2) aus der erfassten Eingangsleistung und der erfassten Ausgangsleistung den aktuellen Wirkungsgrad der Energieübertragung ermittelt.

7. Messgerät nach den Ansprüchen 4-6,
**dadurch gekennzeichnet,**
**dass** der erste Mikrocontroller (1) und/oder der zweite Mikrocontroller (2) aus dem ermittelten Wirkungsgrad bestimmt, ob im Transformator ein Wicklungsbruch vorliegt und im Fall eines Wicklungsbruchs eine entsprechende Fehlermeldung erzeugt.

8. Messgerät nach einem der vorangehenden Ansprüche,
**dadurch gekennzeichnet,**
**dass** der erste Mikrocontroller (1) über verschiedene Betriebsmodi verfügt, welche durch bestimmte Werte mindestens einer Kenngröße des Signals (S1, S2) gekennzeichnet sind,
**dass** jedem Betriebszustand des Messgeräts ein Betriebsmodus zugeordnet ist,
und
**dass** der erste Mikrocontroller (1) in Abhängigkeit des aktuellen Betriebszustandes den entsprechenden Betriebsmodus einstellt.

9. Messgerät nach einem der vorangehenden Ansprüche,
**dadurch gekennzeichnet,**
**dass** der erste Mikrocontroller (1) eine Kennung der Sensoreinheit erfasst, und in Abhängigkeit der vorhandenen Sensoreinheit die mindestens eine Kenngröße des Signals (S1, S2) derart einstellt, dass die Energieübertragung an den Energiebedarf der jeweiligen Sensoreinheit angepasst ist.

10. Verfahren zum Betreiben eines Messgeräts zur Bestimmung und/oder Überwachung mindestens einer Prozessgröße mit mindestens einer Sensoreinheit mit mindestens einem für die Prozessgröße sensitiven Sensor (3), mit einer ersten Elektronikeinheit (5), welche einer Energieversorgungseinheit zugeordnet ist und welche einen ersten Mikrocontroller (1) aufweist, und mit einer zweiten Elektronikeinheit (6), welche der Sensoreinheit zugeordnet ist und einen zweiten Mikrocontroller (2) aufweist, und welche mit der ersten Elektronikeinheit (5) über eine galvanisch getrennte Übertragungseinheit (4) zur Energie- und Datenübertragung verbunden ist,
wobei mindestens ein Signal (S1, S2) mit mindestens einer variierbaren Kenngröße erzeugt und der Übertragungseinheit (4) zugeführt wird, wobei von dem Signal (S1, S2) die Energie- und Datenübertragung gesteuert werden,
**dadurch gekennzeichnet,**
**dass** mindestens ein aktueller Betriebsparameter bestimmt wird,
und
**dass** zumindest eine Kenngröße des Signals (S1, S2) in Abhängigkeit des Betriebsparameters eingestellt wird.

## Claims

1. Measuring device for determining and/or monitoring at least one process variable with a sensor unit with at least one sensor (3) which is sensitive to the process variable, with a first electronics unit (5), which is assigned to an energy supply unit and which has a first microcontroller (1), and with a second electronics unit (6), which is assigned to the sensor unit and has a second microcontroller (2), and which is connected to the first electronics unit (5) via a galvanically isolated transmission unit (4) for energy and data transfer,
wherein the first microcontroller (5) generates at least one signal (S1, S2) which is variable in at least one characteristic variable and transmits the signal to the transmission unit (4),
wherein the signal (S1, S2) controls power and data transmission, **characterized in that**
the first microcontroller (1) and/or the second microcontroller (2) determines at least a current operating parameter,
and
**in that** the first microcontroller (1) sets at least one characteristic variable of the signal (S1, S2) depending on the operating parameter.

2. Measuring device as claimed in Claim 1,
**characterized in that**
the first microcontroller (1) adapts at least one characteristic variable of the signal (S1, S2) to a current operating state of the measuring device and/or sets it in such a way to optimize the level of efficiency of energy transmission.

3. Measuring device as claimed in Claim 1 or 2,
**characterized in that**
the characteristic variable of the signal (S1, S2), which is set by the first microcontroller (1), is the frequency of the signal (S1, S2) and/or the ratio between the pulse duration and the pause duration.

4. Measuring device as claimed in one of the previous claims,
**characterized in that**
the transmission unit (4) has at least one transformer.

5. Measuring device as claimed in Claim 4,
**characterized in that**
the transmission unit (4) is a push-pull converter.

6. Measuring device as claimed in one of the previous claims,
**characterized in that**
the first microcontroller (1) measures a current input power of the transmission unit (4),
the second microcontroller (2) measures a current output power of the transmission unit (4),
and
**in that** the first microcontroller (1) and/or the second microcontroller (2) determine the current level of efficiency of energy transmission from the measured input power and the measured output power.

7. Measuring device as claimed in Claims 4 to 6,
**characterized in that**
on the basis of the level of efficiency determined, the first microcontroller (1) and/or the second microcontroller (2) determines whether there is a winding rupture in the transformer, and, if a winding is ruptured, generates an error message to this effect.

8. Measuring device as claimed in one of the previous claims,
**characterized in that**
the first microcontroller (1) has a variety of operating modes which are **characterized by** certain values of at least one characteristic variable of the signal (S1, S2),
in that an operating mode is assigned to every operating state of the measuring device,
and
in that the first microcontroller (1) sets the appropriate operating mode depending on the current operating state.

9. Measuring device as claimed in one of the previous claims,
**characterized in that**
the first microcontroller (1) measures a characteristic of the sensor unit, and sets the at least one characteristic variable of the signal (S1, S2) as a function of the existing sensor unit in such a way that energy transmission is adapted to the energy needs of the sensor unit in question.

10. Procedure designed to operate a measuring device for determining and/or monitoring at least one process variable with at least one sensor unit with at least one sensor (3) which is sensitive to the process variable, with a first electronics unit (5), which is assigned to a power supply unit and which has a first microcontroller (1), and with a second electronics unit (6), which is assigned to the sensor unit and has a second microcontroller (2), and which is connected to the first electronics unit (5) via a galvanically isolated transmission unit (4) for energy and data transmission,
wherein at least one signal (S1, S2) is generated with at least one variable characteristic variable and supplied to the transmission unit (4),
wherein the transmission of energy and data is controlled by the signal (S1, S2),
**characterized in that**
at least one current operating parameter is determined,
and
**in that** at least one characteristic variable of the signal (S1, S2) is set as a function of the operating parameter.

## Revendications

1. Appareil de mesure destiné à la détermination et/ou la surveillance d'au moins une grandeur process avec une unité de capteur avec au moins un capteur (3) sensible à la grandeur process, avec une première unité électronique (5), laquelle est attribuée à une unité d'alimentation en énergie et laquelle comporte un premier microcontrôleur (1), et avec une deuxième unité électronique (6), laquelle est attribuée à l'unité de capteur et laquelle comporte un deuxième microcontrôleur (2), et laquelle est reliée avec la première unité électronique (5) par l'intermédiaire d'une unité de transmission séparée galvaniquement, destinée à la transmission de l'énergie et des données,
pour lequel le premier microcontrôleur (5) génère au moins un signal (S1, S2) variable selon au moins une grandeur caractéristique, et le transmet à l'unité de transmission (4),
pour lequel le signal (S1, S2) commande la transmission de l'énergie et des données,
**caractérisé**
**en ce que** le premier microcontrôleur (1) et/ou le deuxième microcontrôleur (2) détermine au moins un paramètre de fonctionnement actuel,
et
**en ce que** le premier microcontrôleur (1) règle au moins une grandeur caractéristique du signal (S1, S2) en fonction du paramètre de fonctionnement.

2. Appareil de mesure selon la revendication 1,
**caractérisé**
**en ce que** le premier microcontrôleur (1) adapte au moins une grandeur caractéristique du signal (S1, S2) à un état de fonctionnement actuel de l'appareil de mesure et/ou la règle de telle sorte à optimiser le rendement de la transmission d'énergie.

3. Appareil de mesure selon la revendication 1 ou 2,
**caractérisé**
**en ce que** la grandeur caractéristique du signal (S1, S2), réglée par le premier microcontrôleur (1), est la fréquence du signal (S1, S2) et/ou le rapport entre durée d'impulsion et pause d'impulsion.

4. Appareil de mesure selon l'une des revendications précédentes,
**caractérisé**
**en ce que** l'unité de transmission (4) comporte au moins un transformateur.

5. Appareil de mesure selon la revendication 4,
**caractérisé**
**en ce que**, concernant l'unité de transmission (4), il s'agit d'un transformateur push-pull.

6. Appareil de mesure selon l'une des revendications précédentes,
**caractérisé**
**en ce que** le premier microcontrôleur (1) mesure une puissance d'entrée actuelle de l'unité de transmission (4),
**en ce que** le deuxième microcontrôleur (2) mesure une puissance de sortie de l'unité de transmission (4),
et
**en ce que** le premier microcontrôleur (1) et/ou le deuxième microcontrôleur (2) déterminent à partir de la puissance d'entrée mesurée et de la puissance de sortie mesurée le rendement actuel de la transmission d'énergie.

7. Appareil de mesure selon les revendications 4 à 6,
**caractérisé**
**en ce que** le premier microcontrôleur (1) et/ou le deuxième microcontrôleur (2) déterminent à partir du rendement déterminé s'il y a présence d'une rupture d'enroulement dans le transformateur et, dans le cas d'une rupture d'enroulement, génèrent un message d'erreur correspondant.

8. Appareil de mesure selon l'une des revendications précédentes,
**caractérisé**
**en ce que** le premier microcontrôleur (1) dispose de plusieurs modes de fonctionnement, qui sont **caractérisés par** des valeurs définies d'au moins une grandeur caractéristique du signal (S1, S2),
en ce qu'est attribué un mode de fonctionnement à chaque état de fonctionnement de l'appareil de mesure.

9. Appareil de mesure selon l'une des revendications précédentes,
**caractérisé**
**en ce que** le premier microcontrôleur (1) mesure une caractéristique de l'unité de capteur, et règle en fonction de l'unité de capteur présente l'au moins une grandeur caractéristique du signal (S1, S2) de telle sorte que la transmission d'énergie soit adaptée au besoin en énergie de l'unité de capteur respective.

10. Procédé destiné à l'exploitation d'un appareil de mesure destiné à la détermination et/ou la surveillance d'au moins une grandeur process avec au moins une unité de capteur avec au moins un capteur (3) sensible à la grandeur process, avec une première unité électronique (5), laquelle est attribuée à une unité d'alimentation en énergie et laquelle comporte un premier microcontrôleur (1), et avec une deuxième unité électronique (6), laquelle est attribuée à l'unité de capteur et laquelle comporte un deuxième microcontrôleur (2), et laquelle est reliée avec la première unité électronique (5) par l'intermédiaire d'une unité de transmission séparée galvaniquement, destinée à la transmission de l'énergie et des données,
pour lequel est généré et acheminé à l'unité de transmission (4) au moins un signal (S1, S2) avec au moins une grandeur caractéristique variable,
pour lequel la transmission d'énergie et de donnés est commandée par le signal (S1, S2),
**caractérisé**
**en ce qu'**est déterminé au moins un paramètre de fonctionnement actuel,
et
**en ce qu'**est réglée au moins une grandeur caractéristique du signal (S1, S2) en fonction du paramètre de fonctionnement.
